# EUROPEAN PATENT APPLICATION

(11) **EP 4 372 788 A1**
(43) Date of publication of application: **22.05.2024**
(21) Application number: 22207850.3
(22) Date of filing: 16.11.2022
(51) Int. Cl.: H01L 21/48, H01L 23/498

(54) **METHOD FOR FORMING A POWER SEMICONDUCTOR MODULE ARRANGEMENT**

(71) Applicant: Infineon Technologies AG, 85579 Neubiberg (DE)
(72) Inventor: MEIS, Lukas, 33142 Büren (DE); STROTMANN, Guido, 59609 Anröchte (DE); DREPS, Florian, 33102 Paderborn (DE)
(74) Representative: Westphal, Mussgnug & Partner, Patentanwälte mbB

(57) **Abstract**

A method comprises exerting a pressing force on a section of a first surface of a metal layer by means of a punch, wherein either the metal layer is arranged on a working surface, with a second surface of the metal layer facing the working surface, wherein the second surface is arranged opposite the first surface, and the punch is pressed against the section of the first surface with a pressing force that forces material of the metal layer to flow up against a stroke of the punch, thereby forming a sleeve extending from the first surface in a vertical direction and away from the second surface, or the punch is pressed against the section of the first surface and forced through the metal layer towards the second surface with a pressing force that forces material of the metal layer to flow down with a stroke of the punch, thereby forming a sleeve extending from the second surface in a vertical direction and away from the first surface. The method further comprises, after forming the sleeve, arranging the metal layer in a housing of a power semiconductor module.

## Description

### TECHNICAL FIELD

The instant disclosure relates to a method for forming a power semiconductor module arrangement.

### BACKGROUND

Power semiconductor modules often include a substrate within a housing. The substrate usually comprises a substrate layer (e.g., a ceramic layer), a first metallization layer deposited on a first side of the substrate layer and, optionally, a second metallization layer deposited on a second side of the substrate layer. A semiconductor arrangement including one or more controllable semiconductor elements (e.g., IGBTs, MOSFETs, HEMTs) along with other elements such as passive components, bond wires, etc., may be arranged on the substrate. One or more terminal elements (contact elements), which allow for contacting such a semiconductor arrangement from outside the housing, are usually provided. Power semiconductor modules are known, where the terminal elements are arranged on the substrate and protrude in a direction that is essentially perpendicular to the main surface of the substrate through a cover of the housing.

There is a need for a method for forming a power semiconductor module arrangement that allows to mechanically and electrically couple terminal elements to a metal layer (e.g., metal layer of a substrate) in an efficient and cost-effective manner without creating contaminants that may potentially affect the function of the power semiconductor module.

### SUMMARY

A method includes exerting a pressing force on a section of a first surface of a metal layer by means of a punch, wherein either the metal layer is arranged on a working surface, with a second surface of the metal layer facing the working surface, wherein the second surface is arranged opposite the first surface, and the punch is pressed against the section of the first surface with a pressing force that forces material of the metal layer to flow up against a stroke of the punch, thereby forming a sleeve extending from the first surface in a vertical direction and away from the second surface, or the punch is pressed against the section of the first surface and forced through the metal layer towards the second surface with a pressing force that forces material of the metal layer to flow down with a stroke of the punch, thereby forming a sleeve extending from the second surface in a vertical direction and away from the first surface. The method further includes, after forming the sleeve, arranging the metal layer in a housing of a power semiconductor module.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module.
Figure 2 is a cross-sectional view of another power semiconductor module.
Figure 3, including Figures 3A to 3C, schematically illustrates a method for forming a sleeve on a metal layer using a forming tool according to one embodiment.
Figure 4, including Figures 4A and 4B, schematically illustrates a method for forming a sleeve on a metal layer using a forming tool according to another embodiment.
Figure 5 schematically illustrates a bottom view of a punch with a shaping tool attached thereto according to one embodiment.
Figure 6 schematically illustrates a method for forming a sleeve on a metal layer using a forming tool according to an even further embodiment.
Figure 7 schematically illustrates a method for forming a sleeve on a metal layer using a forming tool according to an even further embodiment.
Figure 8 schematically illustrates a method for forming a sleeve on a metal layer using a forming tool according to an even further embodiment.
Figure 9 schematically illustrates a method for forming a sleeve on a metal layer using a forming tool according to an even further embodiment.
Figure 10 schematically illustrates a method for forming a sleeve on a metal layer using a forming tool according to further embodiments.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or may be included in a semiconductor chip. A semiconductor body has electrically connecting pads and includes at least one semiconductor element with electrodes.

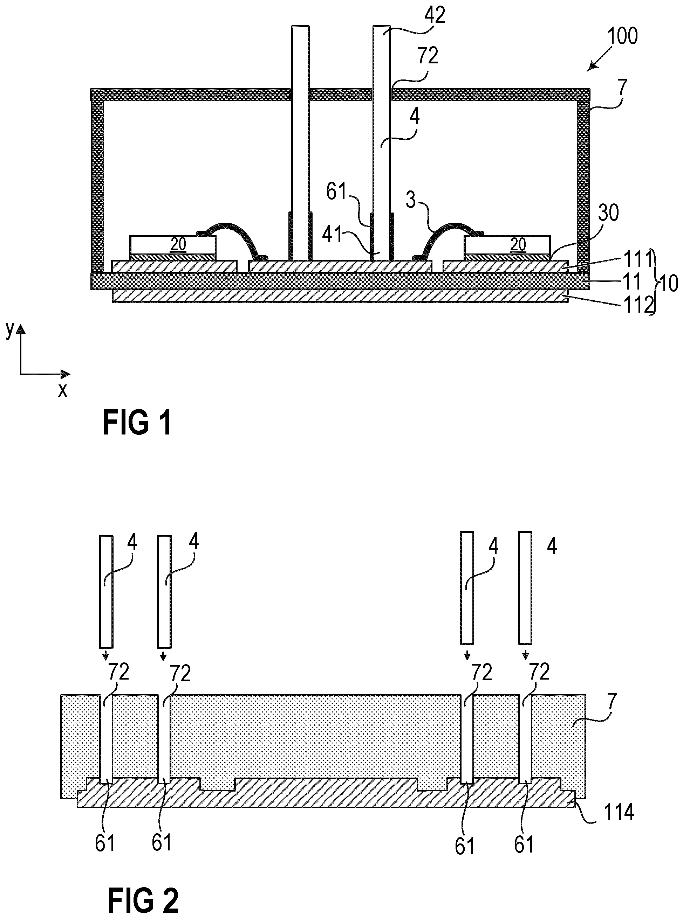

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a ground surface of the housing 7, while the housing 7 itself solely comprises sidewalls and a cover. It is, however, also possible that the substrate 10 be arranged on a ground surface of the housing 7, or on a separate base plate which may be arranged to form a ground surface of the housing 7. In some power semiconductor module arrangements 100, more than one substrate 10 is arranged within the same housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted altogether. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 are mechanically and electrically connected to the substrate 10 (e.g., to the first metallization layer 111) and provide an electrical connection between the inside and the outside of the housing 7. The terminal elements 4 may be mechanically and electrically connected to the first metallization layer 111 with a first end 41, while a second end 42 of the terminal elements 4 protrudes out of the housing 7. The first end 41 of a terminal element 4 may be electrically and mechanically connected to the substrate 10 by inserting the first end 41 into a sleeve or rivet 61, for example. The sleeve or rivet 61 may be mechanically and electrically connected to the substrate 10 by means of an electrically conductive connection layer (not specifically illustrated) such as, e.g., a solder layer, a layer of an electrically conductive adhesive, or a layer of a sintered metal powder, e.g., a sintered silver (Ag) powder. The terminal elements 4 may be electrically contacted from the outside at their second end 42. The housing 7 (i.e., the cover of the housing 7) comprises a plurality of through holes 72. Each of the plurality of terminal elements 4 protrudes vertically through a different one of the plurality of through holes 72.

In addition to the terminal elements 4 described with respect to Figure 1, the components inside the housing 7 may also be electrically contacted from outside the housing 7 in any other suitable way. For example, additional terminal elements 4 may be arranged closer to or adjacent to the sidewalls of the housing 7. It is also possible that terminal elements 4 protrude vertically or horizontally through the sidewalls of the housing 7. The first end 41 of a terminal element 4 may be electrically and mechanically connected to the substrate 10 by inserting the first end 41 into a sleeve or rivet 61.

The power semiconductor module arrangement 100 that has been described by means of Figure 1 above, however, is only an example. It is also possible to implement the power semiconductor module in different ways. As is schematically illustrated in Figure 2, for example, instead of arranging the substrate 10 in a housing 7 comprising sidewalls and a cover, the substrate 10 may be arranged in a molded housing 7. In this example, the housing 7 is formed by a molded body of electrically insulating encapsulant material that covers the substrate 10. In Figure 2, only a metal layer 114 (e.g., first metallization layer) of a substrate is schematically illustrated. The molded housing 7 in this example forms an insulative and protective structure that protects the metal layer 114 and any components (e.g., semiconductor bodies, or electrical connections) arranged thereon. A molded housing can include a wide variety of electrically insulating encapsulant materials including ceramics, epoxy materials and thermosetting plastics, to only name a few. A molded body may be formed by arranging the substrate 10 in a chamber and injecting liquefied encapsulant material into the chamber. Examples of these techniques include injection molding, transfer molding, and compression molding.

Similar to what has been described with respect to Figure 1 above, the arrangement may comprise terminal elements 4 providing an electrical connection between the substrate (e.g., the metal layer 114) and the outside of the housing 7. The housing 7 comprises a plurality of through holes 72, and each of the plurality of terminal elements 4 protrudes vertically through a different one of the plurality of through holes 72. The first end 41 of a terminal element 4 may be electrically and mechanically connected to the substrate 10 by inserting the first end 41 into a sleeve or rivet 61. As is schematically illustrated in Figure 2, the sleeve or rivet 61 may be formed by means of an indentation formed in the metal layer 114.

As has been described with respect to Figure 1 above, sleeves or rivets 61 may be mechanically and electrically coupled to the substrate 10 by an electrically conductive connection layer. Alternatively, as has been described with respect to Figure 2 above, it is also possible that the sleeves or rivets 61 are formed by means of an indentation formed in the metal layer. Forming a sleeve or rivet 61 in or arranging a sleeve or rivet 61 on a metal layer may be cumbersome. Tools that are used to couple a sleeve 61 to the substrate 10 by means of an electrically conductive connection layer usually require a certain amount of space. This needs to be considered when planning the layout of the power semiconductor module arrangement (e.g., the arrangement of the different elements on the substrate 10). Known methods that are used to form indentations in the metal layer that may function as sleeves 61 comprise drilling techniques that create contaminants that may potentially affect the function of the power semiconductor module. The methods according to embodiments described in the following avoid these and other drawbacks of known methods.

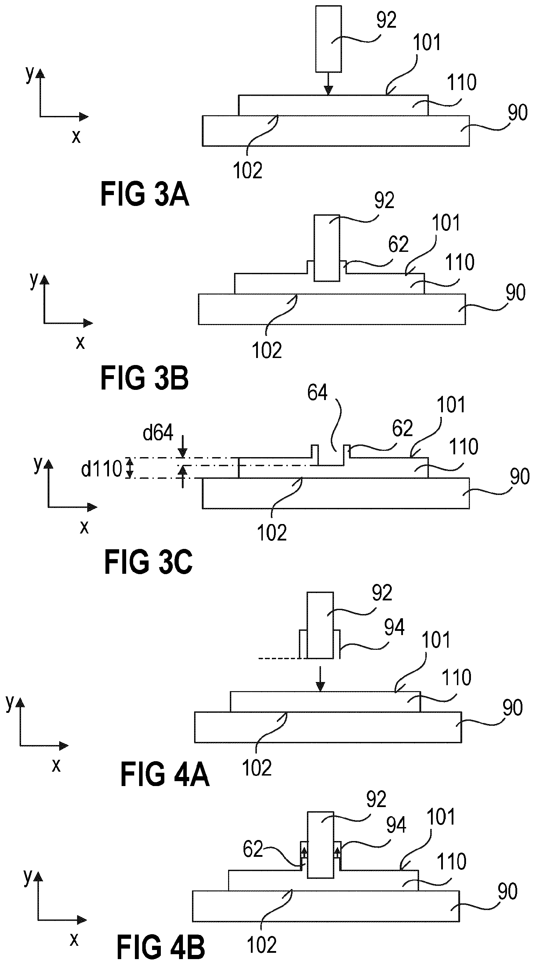

Now referring to Figure 3, a method according to one embodiment of the disclosure is schematically illustrated. In this example, a metal layer 110 is arranged on a working surface 90. The metal layer 110 comprises a first surface 101 and a second surface 102, opposite the first surface 101. As is illustrated in Figure 3A, the metal layer 110 is arranged on the working surface 90 such that the second surface 102 faces the working surface 90 and the first surface 101 faces away from the working surface 90. Now referring to Figure 3B, a pressing force is exerted on a section of the first surface 101 of the metal layer 110 by means of a punch 92. The section of the first surface 101 is small as compared to the overall cross-sectional area of the first surface 101. According to one example, a largest extension of the section is between 0.4 and 5 mm (Millimeters). If the section has a round cross-section, the largest extension corresponds to a diameter of the section, for example. The section, however, may generally have any suitable cross-section, e.g., oval, square, rectangular, polygonal, etc. The section of the first surface 101 being small as compared to the overall cross-sectional area of the first surface 101 means that the punch 92 does not exert a pressing force on the entire first surface 101. The punch 92 does not, or does not significantly compress the material of the metal layer 110. Further, the punch 92 does not remove or ablate material of the metal layer 110. Instead, a backward extruding process is performed in which material of the metal layer 110 is merely displaced. That is, as the punch 92 is pressed against the section of the first surface 101, the resulting pressing force forces material of the metal layer 110 to flow up against a stroke of the punch 92, thereby forming a sleeve 62 extending from the first surface 101 in a vertical direction y and away from the second surface 102. The working surface 90 on which the metal layer 110 is arranged, prevents the material of the metal layer 110 from flowing down with a stroke of the punch 92. The material of the metal layer 110 arranged horizontally adjacent to the section of the metal layer 110 to which the pressing force is applied prevents the material from flowing in a horizontal direction x. That is, the vertical direction y in a direction up against the stroke of the punch 92 is the only direction into which the material can flow, thereby forming the sleeve 62.

The material of the metal layer 110 forming the sleeve 62 is displaced by pressing the punch 92 on the first surface 101 and moving it towards the second surface 102. In this way, a hole 64 is formed in the metal layer 110. A depth d64 of the resulting hole 64 in the example illustrated in Figure 3C is less than a thickness d110 of the metal layer 110. That is, a thin layer of metal remains between the hole 64 and the second surface 102.

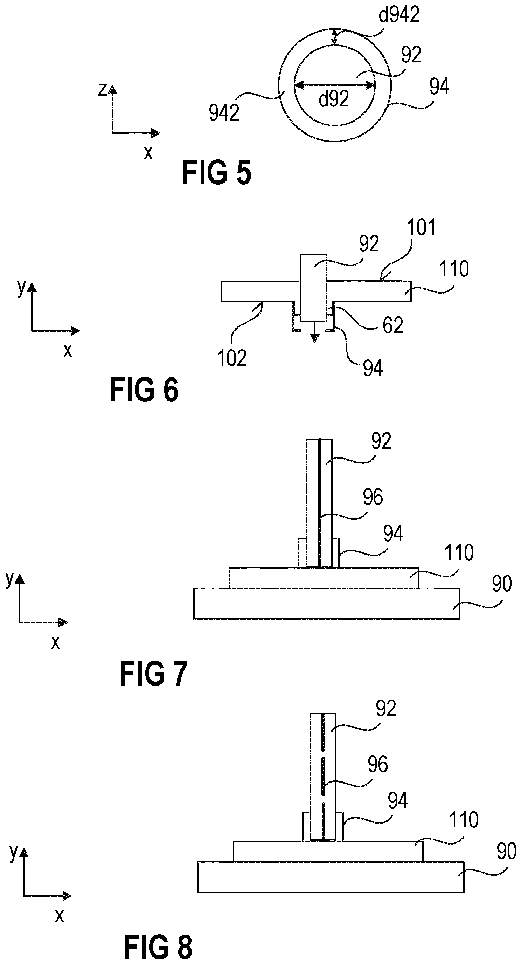

Forming the sleeve 62 in a desired shape may be supported by means of a shaping tool 94, for example. As is illustrated in Figure 3 and as has been described above, there is generally only one direction in which the material of the metal layer 110 may be displaced when forming the hole 64. A shaping tool 94, which is schematically illustrated in Figure 4, may be used in order to form a sleeve 62 having a desired wall thickness, for example. As is schematically illustrated in Figure 4A, the shaping tool 94 may comprise a sleeve circumferentially surrounding the punch 92 at a distance d942. In this way, a cavity 942 is formed between the punch 92 and the shaping tool 94 that has the shape of a hollow cylinder. A wall thickness of the resulting sleeve 62 corresponds to the distance d942. Figure 5, in a bottom view, schematically illustrates the cavity 942 formed between the punch 92 and the shaping tool 94.

The shaping tool 94 may be movably attached to the punch 92, for example. That is, the shaping tool 94 may move in a vertical direction y with respect to the punch 92. In an initial position, an end of the shaping tool 94 that faces the first surface 101 may be aligned with an end of the punch 92 facing the first surface 101, as is illustrated by means of the dashed line in Figure 4A. That is, the punch 92 and the shaping tool 94 may contact the first surface 101 essentially at the same time. While the punch 92 penetrates into the metal layer 110, thereby forming the hole 64 and forming the sleeve 62, the shaping tool 94 (i.e., the end of the shaping tool 94 facing the first surface 101) may rest on the first surface 101 without penetrating into the metal layer 110. While the punch 92 moves from the first surface 101 towards the second surface 102, the shaping tool 94 moves with respect to the punch 92 such that it may remain in its position on the first surface 101. It is, however, also possible that the shaping tool 94 also exerts a certain force on the metal layer 110, however, without significantly penetrating into the metal layer 110. If the shaping tool 94 exerts a certain force on the metal layer 110, thereby denting it to a certain degree, the flow of the material may be controlled to a higher degree. A defined indentation caused by the shaping tool may initiate the deformation of the material. The flowability of the material of the metal layer 110 may be further promoted by suitable chemical treatment of the metal layer 110 (e.g., suitable coating) or by physical treatment (e.g., thermal treatment).

The cavity 942 formed between the punch 92 and the shaping tool 94 is the only volume available for the material that is being displaced by the punch 92 such that it fills the cavity 942 at least partly. The geometry of the punch 92 as well as of the (optional) shaping tool 94 may have an influence on the process. The shape of the resulting sleeve 62 may be determined by the geometry of the punch 92 and/or the shaping tool 94, e.g., by means of specific radii, chamfers, indentations, etc. of the punch 92 and/or shaping tool 94.

Forming a sleeve 62 that extends from the first surface 101 in a vertical direction y and away from the second surface 102, however, is only an example. According to another example, and as is schematically illustrated in Figure 6, it is alternatively also possible to form a sleeve 62 that extends from the second surface 102 in a vertical direction y and away from the first surface 101. The metal layer 110 in this case is not arranged on a working surface 90. The punch 92 is pressed against the section of the first surface 101 and is forced through the metal layer 110 towards the second surface 102 with a pressing force that forces material of the metal layer 110 to flow down with a stroke of the punch 92. As there is no working surface 90 forming a barrier for the material of the metal layer 110, the vertical direction y in a direction away from the first surface 101 is a preferred direction into which the material of the metal layer displaced by the punch 92 will flow. The sleeve 62, therefore, is formed on an opposite side of the metal layer 110, as compared to what has been described with respect to Figures 3 and 4 above. The punch 92, however, in this example penetrates all the way through the metal layer 110 from the first surface 101 to the second surface 102. That is, a depth of a hole formed by the punch 92 in the metal layer 110 corresponds to the thickness d110 of the metal layer 110. The punch 92 may penetrate through the metal layer 110 even further, in order to form the sleeve 62, as is schematically illustrated in Figure 6.

Similar to what has been described with respect to Figures 4 and 5 above, a shaping tool 94 may be provided in order to form a sleeve 62 having a desired shape (e.g., with a desired wall thickness). The shaping tool 94 in this example is not attached to the punch 92. Instead, the shaping tool 94 is provided on the opposite side of the metal layer 110 (i.e. on the side of the second surface 102). This is, because the material of the metal layer 110 flows in the opposite direction as compared to the example described above. The shaping tool 94 may have a similar shape as the shaping tool of the examples of Figures 4 and 5. That is, the shaping tool 94 may comprise a sleeve. The shaping tool 94 may be arranged to contact the second surface 102 of the metal layer 110. According to one example, the shaping tool 94 is pressed onto the second surface 102 with a certain amount of force. The punch 92 is pushed through the metal layer 110 and is moved even further into the vertical direction y into the shaping tool 94. In this way, a cavity between the punch 92 and the shaping tool 94 is formed, similar to what has been described with respect to Figure 5 above. The material of the metal layer 110 that is displaced by the punch 92 flows into this cavity, thereby forming the sleeve 62. The punch 92, while not being connected to the shaping tool 94, is also movable with respect to the shaping tool 94 or, more specifically, the punch 92 is movable with respect to the shaping tool 94.

For some applications, forming the sleeve 62 by displacing the material of the metal layer 110 is sufficient. That is, there is enough material available to form the sleeve 62 in a desired size, shape and desired dimensions. It is, however, also possible to provide additional material. Now referring to Figure 7, a channel 96 may be provided in the punch 92. The channel 96 may extend vertically through the punch 92 and may have an opening at the end of the punch 92 that contacts the metal layer 110. Additional material may flow through the channel 96. According to one example, material may flow through the channel 96 continuously while forming the sleeve 62. The additional material may mix with the material of the metal layer 110, thereby forming the sleeve 62. In other words, the additional material may be kneaded into the material of the metal layer 110 that is displaced by means of the punch 92 to form the sleeve 62. The additional material may be the same as or may differ from the material of the metal layer 110. For example, the metal layer 110 may consist of or comprise a comparably cheap material such as, e.g., aluminum. The additional material may consist of or comprise a comparably expensive material such as, e.g., copper or gold, which has better electrical properties as compared to aluminum.

In the example illustrated in Figure 7, the additional material is provided by an endless strand. It is, however, also possible to provide defined amounts of additional material while forming the sleeve 62. This is schematically illustrated in Figure 8. The additional material in this example may also be provided through a channel in the punch 92. Additional material from an endless strand as well as in defined amounts, however, may also be provided in any other suitable way.

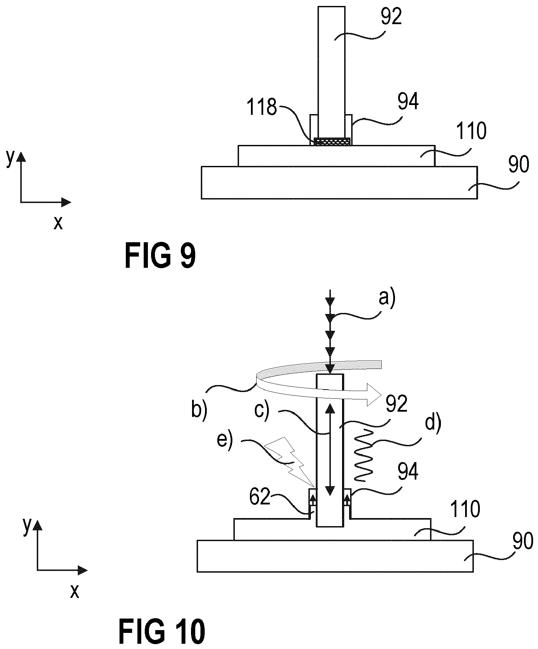

In the examples illustrated in Figures 7 and 8, the additional material is mostly or entirely provided at the same time when forming the sleeve 62 (while exerting a pressing force on a section of the first surface 101 of the metal layer 110 by means of the punch 92). As is schematically illustrated in Figure 9, it is however also possible that additional material is provided, at least partly, before exerting a pressing force by means of the punch 92. That is, a layer of additional material 118 may be formed on the metal layer 118. This layer of additional material 118 may be formed in any suitable way. The punch 92 may then be arranged on the layer of additional material 118 and exert a pressing force on the metal layer 110. The additional material in this example mixes with the material of the metal layer 110 similar to what has been described with respect to Figures 7 and 8 above.

Exerting a force on the metal layer 110 by means of a punch 92 may comprise pressing the punch 92 on the material of the metal layer 110 with a constant force without any additional movement of the punch 92. The material of the metal layer reaches its yield point under load and deforms plastically. Now referring to Figure 10, forming the sleeve 62 by means of the punch 92 may be further promoted in different ways. For example, exerting a pressing force on a section of a first surface 101 of a metal layer 110 by means of a punch 92 may comprise moving the punch 92 from the first surface 101 towards the second surface 102 in a pulsed manner. That is, the force transmitted by the punch is increased incrementally in a repetitive manner. This is schematically illustrated by means of the series of short arrows (Example a). Alternatively or additionally, exerting a pressing force on a section of a first surface 101 of a metal layer 110 by means of a punch 92 may comprise rotating the punch 92. By rotating the punch 92, the material of the metal layer 110 can be more easily set in motion. The resulting friction generates heat which further assists the deformation of the material, as the yield point of the material is reached earlier. This is schematically illustrated by means of the bent arrow (Example b). The punch 92 may be helical, threaded, or spiral-shaped, for example, or have any other shape that results in the punch 92 drilling into the metal layer 110 without resulting in an ablation of the material.

Alternatively or additionally, exerting a pressing force on a section of a first surface 101 of a metal layer 110 by means of a punch 92 may comprise oscillating the punch 92. An oscillating movement of the punch may have a similar effect as moving the punch 92 in a pulsed manner, as has been described above. When moving the punch 92 in an oscillating manner, however, the material of the metal layer 110 is repeatedly relieved for a short moment. This is schematically illustrated by means of the double-sided arrow in Figure 10 (Example c). Alternatively or additionally, exerting a pressing force on a section of a first surface 101 of a metal layer 110 by means of a punch 92 may comprise performing an ultrasonic supported material forming. That is, the process of forming the sleeve 62 may be supported by means of ultrasound, similar to conventional ultrasonic welding techniques. In particular, similar effects as in ultrasonic welding techniques may be achieved. For example, the material of the metal layer 110 may heat up due to the alternating strain caused by the ultrasound, thereby reducing the yield point of the material of the metal layer 110. In Figure 10, this is schematically illustrated by means of the oscillating line (Example d).

Alternatively or additionally, exerting a pressing force on a section of a first surface 101 of a metal layer 110 by means of a punch 92 may comprise applying heat to the metal layer 110 such that the yield point of the material is reached earlier. In this way, the force exerted by the punch 92 may be minimized. This is schematically illustrated by means of the flash (Example e). Heat may be generated in any suitable way. As has been described above, applying ultrasound or rotating the punch 92 may result in the generation of heat. It is, however, also possible to generate heat in any other suitable way such as, e.g., conductively, inductively or by means of an electromagnetic light source (e.g., laser, microwave, etc.).

In Figure 10, the metal layer 110 is arranged on a working surface 90. It is, however, also possible to apply one or more of the supporting measures as described above for a metal layer 110 that is not arranged on a working surface 90, as is described with respect to Figure 6, for example.

With the methods described above, a sleeve 62 may be formed from the material of the metal layer 110. That is, the sleeve 62 and the metal layer 110 form a single piece. No connection procedure is required to mechanically couple a separate sleeve to the metal layer 110. The sleeve 62 is formed by means of a (backwards) extrusion process (see, e.g., DIN 8583). That is, a plastic deformation of the material occurs.

Generally speaking, a method for forming a sleeve 62 on a metal layer 110 comprises exerting a pressing force on a section of a first surface 101 of a metal layer 110 by means of a punch 92, wherein either the metal layer 110 is arranged on a working surface 90, with a second surface 102 of the metal layer 110 facing the working surface 90, wherein the second surface 102 is arranged opposite the first surface 101, and the punch 92 is pressed against the section of the first surface 101 with a pressing force that forces material of the metal layer 110 to flow up against a stroke of the punch 92, thereby forming a sleeve 62 extending from the first surface 101 in a vertical direction y and away from the second surface 102. Alternatively, the punch 92 is pressed against the section of the first surface 101 and forced through the metal layer 110 towards the second surface 102 with a pressing force that forces material of the metal layer 110 to flow down with a stroke of the punch 92, thereby forming a sleeve 62 extending from the second surface 102 in a vertical direction y and away from the first surface 101.

The metal layer 110 may be the metal layer of a substrate 10. That is, the metal layer 110 may be arranged on a dielectric insulation layer 11, as has been described with respect to Figures 1 and 2 above. The metal layer 110 may be arranged on a dielectric insulation layer 11 before forming the sleeve 62 or after forming the sleeve 62. The dielectric insulation layer 11 may be a ceramic layer consisting of or comprising aluminum oxide, aluminum nitride, zirconium oxide, silicon nitride, boron nitride, silicon carbide, beryllium oxide, or boron nitride, for example. Alternatively, the dielectric insulation layer 11 may be an Insulated Metal Substrate comprising epoxy resin or polyimide. According to an even further example, the dielectric insulation layer 11 may be a non-ceramic dielectric insulation layer 11 consisting of or including a cured resin. The metal layer 110 may comprise or consist of copper, a copper alloy, aluminum, or an aluminum alloy, for example.

If the metal layer 110 is arranged on the dielectric insulation layer 11 after forming the sleeve 62, it is arranged on the dielectric insulation layer 11 such that the sleeve 62 faces away from the dielectric insulation layer 11. After forming the sleeve 62, the metal layer 110 is arranged in a housing 7 of a power semiconductor module 100. The metal layer 110 may be arranged on a dielectric insulation layer 11 before arranging the metal layer 110 in the housing 7. The method for forming a sleeve 62 may be repeated several times, for example, in order to form a plurality of sleeves 62 on the metal layer 110. It is, however, also possible to form a plurality of sleeves 62 simultaneously.

A terminal element 4 may be arranged in the sleeve 62, similar to what has been described with respect to Figures 1 and 2 above, wherein the terminal element 4 is configured to provide an electrical connection between the metal layer 110 and the outside of the housing 7. According to one example, the punch 92 is a dedicated tool for forming the sleeve 62 and is removed once forming of the sleeve 62 has been completed. It is, however, also possible that a terminal element 4 is used as a punch 92. In this case, the terminal element 4 may remain in the sleeve 62 once forming of the sleeve 62 has been completed. In this case, a separate step of inserting a terminal element 4 into the sleeve 62 is not required. A terminal element 4 may have a diameter of, e.g., 0.4 to 5 mm. An inner diameter of the sleeve 62 may correspond to or may be slightly smaller than the diameter of the terminal element 4. In this way, the terminal element 4 is pressed into the sleeve 62, thereby forming a stable connection between the terminal element 4 and the sleeve 62. As is illustrated in Figure 5, for example, a diameter d92 of the punch 92 may correspond to the inner diameter of the resulting sleeve 62.

The punch 92 illustrated in Figure 5 has a round cross-section. This, however, is only an example. The punch 92 may generally have any suitable cross-section, e.g., oval, square, rectangular, polygonal, etc. The cross-section of the punch 92 may correspond to the cross-section of the terminal element 4 that is to be inserted into the sleeve 62. It is, however, also possible that the cross-section of the terminal element 4 inserted into a sleeve 62 differs from the cross-section of the sleeve 62. For example, a terminal element 4 having a square cross-section may be inserted into a sleeve 62 having a round cross-section. In this case, the terminal element 4 cants when being pressed into the sleeve 62. In this way, a mechanically stable connection between the terminal element 4 and the sleeve 62 may be formed. Other cross-sections, however, are also possible.

According to an even further example, the sleeve 62 may be formed such that a thread is formed on its inner diameter. A terminal element 4 may comprise a matching thread and may be screwed into the sleeve 62. In this way, a detachable connection may be formed between the terminal element 4 and the sleeve 4. That is, the terminal element 4 may be removed from the sleeve 62 without damaging the sleeve 62 and/or the terminal element 4.

## Claims

1. A method comprising:
exerting a pressing force on a section of a first surface (101) of a metal layer (110) by means of a punch (92), wherein
either the metal layer (110) is arranged on a working surface (90), with a second surface (102) of the metal layer (110) facing the working surface (90), wherein the second surface (102) is arranged opposite the first surface (101), and the punch (92) is pressed against the section of the first surface (101) with a pressing force that forces material of the metal layer (110) to flow up against a stroke of the punch (92), thereby forming a sleeve (62) extending from the first surface (101) in a vertical direction (y) and away from the second surface (102), or
the punch (92) is pressed against the section of the first surface (101) and forced through the metal layer (110) towards the second surface (102) with a pressing force that forces material of the metal layer (110) to flow down with a stroke of the punch (92), thereby forming a sleeve (62) extending from the second surface (102) in a vertical direction (y) and away from the first surface (101); and
after forming the sleeve (62), arranging the metal layer (110) in a housing (7) of a power semiconductor module (100).

2. The method of claim 1, further comprising arranging the metal layer (110) on a dielectric insulation layer (11), before arranging the metal layer (110) in the housing (7), wherein the metal layer (110) is arranged on the dielectric insulation layer (11) such that the sleeve (62) faces away from the dielectric insulation layer (11).

3. The method of claim 2, wherein arranging the metal layer (110) on a dielectric insulation layer (11) comprises
arranging the metal layer (110) on a ceramic layer consisting of or comprising aluminum oxide, aluminum nitride, zirconium oxide, silicon nitride, boron nitride, silicon carbide, beryllium oxide, or boron nitride, or
arranging the metal layer (110) on an Insulated Metal Substrate comprising epoxy resin or polyimide, or arranging the metal layer (110) on a non-ceramic dielectric insulation layer (11) consisting of or including a cured resin.

4. The method of any of claims 1 to 3, further comprising
arranging a terminal element (4) in the sleeve (62), wherein the terminal element (4) is configured to provide an electrical connection between the metal layer (110) and the outside of the housing (7).

5. The method of any of claims 1 to 4, wherein exerting a pressing force on a section of a first surface (101) of a metal layer (110) by means of a punch (92) comprises exerting a pressing force on a section of a first surface (101) of a metal layer (110) comprising or consisting of copper, a copper alloy, aluminum, or an aluminum alloy.

6. The method of any of the preceding claims, wherein exerting a pressing force on a section of a first surface (101) of a metal layer (110) by means of a punch (92) comprises exerting a pressing force on a section of a first surface (101) of a metal layer (110) by means of a punch (92) comprising a shaping tool (94), wherein the shaping tool (94) comprises a sleeve circumferentially surrounding the punch (92).

7. The method of any of the preceding claims, wherein exerting a pressing force on a section of a first surface (101) of a metal layer (110) by means of a punch (92) comprises moving the punch (92) from the first surface (101) towards the second surface (102) in a pulsed manner.

8. The method of any of the preceding claims, wherein exerting a pressing force on a section of a first surface (101) of a metal layer (110) by means of a punch (92) comprises rotating the punch (92).

9. The method of any of the preceding claims, wherein exerting a pressing force on a section of a first surface (101) of a metal layer (110) by means of a punch (92) comprises oscillating the punch (92).

10. The method of any of the preceding claims, wherein exerting a pressing force on a section of a first surface (101) of a metal layer (110) by means of a punch (92) comprises performing an ultrasonic supported material forming.

11. The method of any of the preceding claims, wherein exerting a pressing force on a section of a first surface (101) of a metal layer (110) by means of a punch (92) comprises applying heat to the metal layer (110).

12. The method of any of the preceding claims, further comprising, before exerting a pressing force on a section of a first surface (101) of a metal layer (110) by means of a punch (92), forming a layer of electrically conducting material (118) on the section of the first surface (101).

13. The method of any of the preceding claims, further comprising, during the step of exerting a pressing force on a section of a first surface (101) of a metal layer (110) by means of a punch (92), supplying a defined quantity of electrically conducting material (96) to the metal layer (110) by means of a channel extending through the punch (92).

14. The method of any of the preceding claims, wherein exerting a pressing force on a section of a first surface (101) of a metal layer (110) by means of a punch (92) comprises exerting a pressing force on a section of the first surface (101) having a largest extension of between 0.4 and 5 mm.

## Amended claims

### Amended claims in accordance with Rule 137(2) EPC.

1. A method comprising:
exerting a pressing force on a section of a first surface (101) of a metal layer (110) by means of a punch (92), wherein
either the metal layer (110) is arranged on a working surface (90), with a second surface (102) of the metal layer (110) facing the working surface (90), wherein the second surface (102) is arranged opposite the first surface (101), and the punch (92) is pressed against the section of the first surface (101) with a pressing force that forces material of the metal layer (110) to flow up against a stroke of the punch (92), thereby forming a sleeve (62) extending from the first surface (101) in a vertical direction (y) and away from the second surface (102), wherein exerting a pressing force on a section of a first surface (101) of a metal layer (110) by means of a punch (92) comprises exerting a pressing force on a section of a first surface (101) of a metal layer (110) by means of a punch (92) comprising a shaping tool (94), wherein the shaping tool (94) comprises a sleeve circumferentially surrounding the punch (92), or
the punch (92) is pressed against the section of the first surface (101) and forced through the metal layer (110) towards the second surface (102) with a pressing force that forces material of the metal layer (110) to flow down with a stroke of the punch (92), thereby forming a sleeve (62) extending from the second surface (102) in a vertical direction (y) and away from the first surface (101); and
after forming the sleeve (62), arranging the metal layer (110) in a housing (7) of a power semiconductor module (100).

2. The method of claim 1, further comprising arranging the metal layer (110) on a dielectric insulation layer (11), before arranging the metal layer (110) in the housing (7), wherein the metal layer (110) is arranged on the dielectric insulation layer (11) such that the sleeve (62) faces away from the dielectric insulation layer (11).

3. The method of claim 2, wherein arranging the metal layer (110) on a dielectric insulation layer (11) comprises
arranging the metal layer (110) on a ceramic layer consisting of or comprising aluminum oxide, aluminum nitride, zirconium oxide, silicon nitride, boron nitride, silicon carbide, beryllium oxide, or boron nitride, or
arranging the metal layer (110) on an Insulated Metal Substrate comprising epoxy resin or polyimide, or
arranging the metal layer (110) on a non-ceramic dielectric insulation layer (11) consisting of or including a cured resin.

4. The method of any of claims 1 to 3, further comprising
arranging a terminal element (4) in the sleeve (62), wherein the terminal element (4) is configured to provide an electrical connection between the metal layer (110) and the outside of the housing (7).

5. The method of any of claims 1 to 4, wherein exerting a pressing force on a section of a first surface (101) of a metal layer (110) by means of a punch (92) comprises exerting a pressing force on a section of a first surface (101) of a metal layer (110) comprising or consisting of copper, a copper alloy, aluminum, or an aluminum alloy.

6. The method of any of the preceding claims, wherein exerting a pressing force on a section of a first surface (101) of a metal layer (110) by means of a punch (92) comprises moving the punch (92) from the first surface (101) towards the second surface (102) in a pulsed manner.

7. The method of any of the preceding claims, wherein exerting a pressing force on a section of a first surface (101) of a metal layer (110) by means of a punch (92) comprises rotating the punch (92).

8. The method of any of the preceding claims, wherein exerting a pressing force on a section of a first surface (101) of a metal layer (110) by means of a punch (92) comprises oscillating the punch (92).

9. The method of any of the preceding claims, wherein exerting a pressing force on a section of a first surface (101) of a metal layer (110) by means of a punch (92) comprises performing an ultrasonic supported material forming.

10. The method of any of the preceding claims, wherein exerting a pressing force on a section of a first surface (101) of a metal layer (110) by means of a punch (92) comprises applying heat to the metal layer (110).

11. The method of any of the preceding claims, further comprising, before exerting a pressing force on a section of a first surface (101) of a metal layer (110) by means of a punch (92), forming a layer of electrically conducting material (118) on the section of the first surface (101).

12. The method of any of the preceding claims, further comprising, during the step of exerting a pressing force on a section of a first surface (101) of a metal layer (110) by means of a punch (92), supplying a defined quantity of electrically conducting material (96) to the metal layer (110) by means of a channel extending through the punch (92).

13. The method of any of the preceding claims, wherein exerting a pressing force on a section of a first surface (101) of a metal layer (110) by means of a punch (92) comprises exerting a pressing force on a section of the first surface (101) having a largest extension of between 0.4 and 5 mm.
